(19) Europäisches Patentamt
European Patent Office
Office européen des brevets

(11) **EP 1 950 612 A1**

(12) **EUROPEAN PATENT APPLICATION**
published in accordance with Art. 158(3) EPC

(43) Date of publication:
**30.07.2008 Bulletin 2008/31**

(51) Int Cl.:
**G03F 7/20** (2006.01)  **H01L 21/027** (2006.01)

(21) Application number: **06823081.2**

(86) International application number:
**PCT/JP2006/322168**

(22) Date of filing: **07.11.2006**

(87) International publication number:
**WO 2007/055199 (18.05.2007 Gazette 2007/20)**

(84) Designated Contracting States:
**AT BE BG CH CY CZ DE DK EE ES FI FR GB GR HU IE IS IT LI LT LU LV MC NL PL PT RO SE SI SK TR**

(30) Priority: **09.11.2005 JP 2005324618**

(71) Applicant: **NIKON CORPORATION**
**Tokyo 100-8331 (JP)**

(72) Inventor: **NAGASAKA, Hiroyuki**
**Tokyo; 100-8331 (JP)**

(74) Representative: **Hooiveld, Arjen Jan Winfried**
**Arnold & Siedsma**
**Sweelinckplein 1**
**2517 GK Den Haag (NL)**

(54) **EXPOSURE APPARATUS AND METHOD, AND METHOD FOR MANUFACTURING DEVICE**

(57)    An exposure apparatus (EX) includes an optical system (PL) having a plurality of optical members through which exposure light (EL) passes respectively and that are positioned so as to face a substrate (P), and a liquid immersion system (1) that causes a space between each of the optical members and the substrate (P) to be filled with the liquid (LQ). The substrate (P) is exposed via the liquid (LQ) and at least one of the optical members.

FIG. 1

## Description

TECHNICAL FIELD

The present invention relates to an exposure apparatus and method for exposing a substrate, and to a device manufacturing method.

Priority is claimed on Japanese Patent Application No. 2005-324618, filed on November 9, 2005, the contents of which are incorporated herein by reference.

BACKGROUND ART

In the photolithography process, a liquid immersion type of exposure apparatus, such as that disclosed in the following patent document, is known in which a substrate is exposed via a projection optical system and a liquid.
Patent Document 1
PCT International Patent Publication No. WO 99/49504

DISCLOSURE OF INVENTION

PROBLEMS TO BE SOLVED BY THE INVENTION

In this exposure apparatus, because the resolution thereof improves the shorter the wavelength of the exposure light being used, in a liquid immersion type of exposure apparatus the resolution is improved by utilizing the fact that the wavelength of exposure light in a liquid becomes substantially shorter in accordance with the refractive index of the liquid. Moreover, in an exposure apparatus, although the resolution is improved as the numerical aperture of the projection optical system increases, if the numerical aperture of the projection optical system is increased there is a possibility that, for example, the size of the optical components (i.e., the lenses and the like) of the projection optical system will increase.

An object of the present invention is to provide an exposure apparatus and method that, for example, suppress any increase in optical component size and allows resolution to be improved while allowing desired optical characteristics to be maintained, and also to provide a device manufacturing method that uses this exposure apparatus and exposure method.

MEANS FOR SOLVING THE PROBLEM

The present invention adopts the following configuration corresponding to the drawings illustrating the embodiments. However, parenthesized reference characters affixed to the respective elements are merely examples of those elements, and they do not limit the respective elements.

According to a first aspect of the present invention, there is provided an exposure apparatus (EX) that exposes a substrate (P) via a liquid (LQ) using exposure light (EL), and that includes: an optical system (PL) having a plurality of optical members (FLa-FLh), the exposure light (EL) passing though each of the optical members, the substrate (P) being positioned opposite the optical members; and a liquid immersion (10, etc.) system that causes a space between each of the optical members (FLa-FLh) and the substrate (P) to be filled with the liquid (LQ).

According to the first aspect of the present invention, it is possible to improve resolution while restricting any increase in the size of the optical elements and maintaining desired optical characteristics.

According to a second aspect of the present invention, there is provided an exposure apparatus (EX) that exposes a substrate (P) via a liquid (LQ) using exposure light (EL), and that includes: an optical system (PL) having a plurality of optical members (FLa-FLh), irradiation areas (50a-50h) of the exposure light from the optical members being in different positions in at least a first direction (Y axis direction) on a predetermined plane; a movement system (4, etc.) that, during the exposure, moves the plurality of irradiation areas (50a-50h) and the substrate relatively to each other in a second direction (X axis direction) that intersects the first direction; and a liquid immersion system (10, etc.) that, during the exposure, fills a space between at least one of the optical members (50a-50h) through which the exposure light passes and the substrate with the liquid so as to form a liquid immersion space.

According to the second aspect of the present invention, it is possible to form a pattern on a substrate at a high resolution while restricting any increase in the size of the optical elements.

According to a third aspect of the present invention, there is provided a device manufacturing method that uses the exposure apparatus (EX) according to the above described aspects.

According to the third aspect of the present invention, it is possible to manufacture a device using an exposure apparatus that has an improved resolution while restricting any increase in the size of the optical elements.

According to a fourth aspect of the present invention, there is provided an exposure method for exposing a substrate (P) via a liquid (LQ) using exposure light (EL), the method including: forming a liquid immersion space for the liquid (LQ) between at least one of optical members (50a-50h) through which the exposure light passes and the substrate; and exposing the substrate by the exposure light via at least one of the optical members (50a-50h) and the liquid in the liquid immersion space.

According to the fourth aspect of the present invention, it is possible to form a pattern on a substrate at a high resolution while restricting any increase in the size of the optical elements.

According to a fifth aspect of the present invention, there is provided a device manufacturing method that uses the exposure method according to the above described aspect.

According to the fifth aspect of the present invention, it is possible to manufacture a device having detailed design rules.

## BRIEF DESCRIPTION OF THE DRAWINGS

FIG. 1 is a schematic structural view showing an exposure apparatus according to a first embodiment of the present invention.

FIG. 2 is a schematic perspective view showing an exposure apparatus according to the first embodiment of the present invention.

FIG 3 is a perspective view as seen from above of a projection system and immersion system.

FIG. 4 is a perspective view as seen from below of a projection system and an immersion system.

FIG. 5 is a plan view as seen from below of a projection system and an immersion system.

FIG. 6 is a schematic structural view showing a projection system and an immersion system.

FIG. 7 is a plan view showing a projection area of a projection module.

FIG. 8 is a typical view showing a relationship between a projection area and an immersion area.

FIG 9 is a typical view showing a relationship between a projection area and a shot area.

FIG 10 is a schematic structural view showing a projection system and an immersion system according to a second embodiment.

FIG. 11 is a schematic structural view showing a projection system and an immersion system according to a third embodiment.

FIG. 12 is a cross-sectional view showing an enlargement of principal portions of FIG. 11.

FIG. 13 is a typical view showing a relationship between a projection area and a shot area.

FIG. 14 is a schematic structural view showing a projection system and an immersion system according to a fourth embodiment.

FIG. 15 is a flow chart for illustrating an example of a micro device manufacturing process.

## DESCRIPTION OF THE REFERENCE SYMBOLS

1: IMMERSION SYSTEM, 7: CONTROL UNIT, 12: SUPPLY PORT, 22: COLLECTION PORT, 50a-50h: PROJECTION AREA, 60: PLATE COMPONENT, 61: BOTTOM SURFACE, 70: NOZZLE COMPONENT, 71: BOTTOM SURFACE, EL: EXPOSURE LIGHT, EX: EXPOSURE APPARATUS, FLa-FLh: FINAL OPTICAL ELEMENT, LQ: LIQUID, LR: LIQUID IMMERSION AREA, P: SUBSTRATE, PL: PROJECTION OPTICAL SYSTEM, PLa-PLh: PROJECTION MODULE, Ta-Th: BOTTOM SURFACE

## BEST MODE FOR CARRYING OUT THE INVENTION

Embodiments of the present invention will now be described with reference made to the drawings. It should be noted, however, that the present invention is not limited to these embodiments.

<First embodiment>

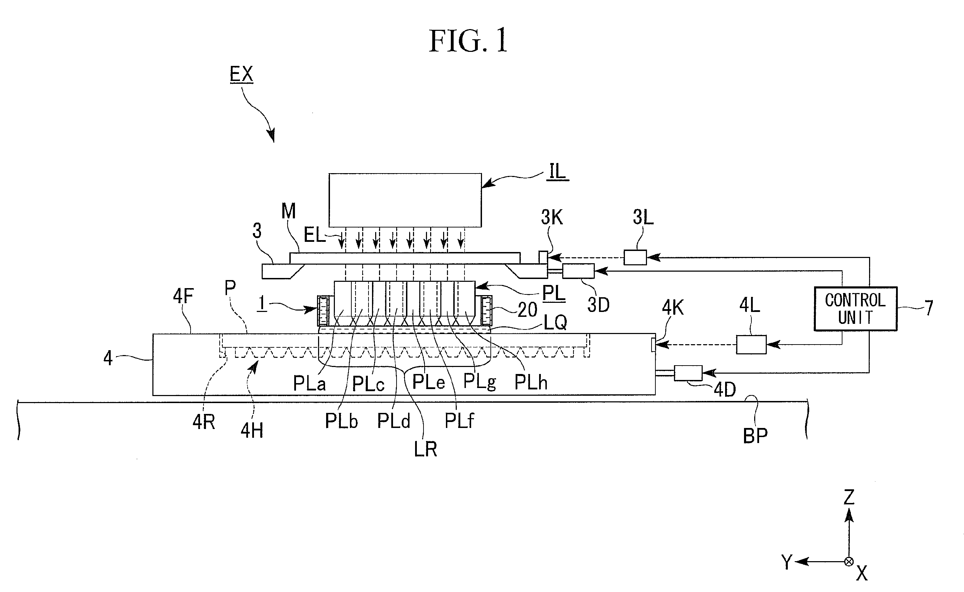

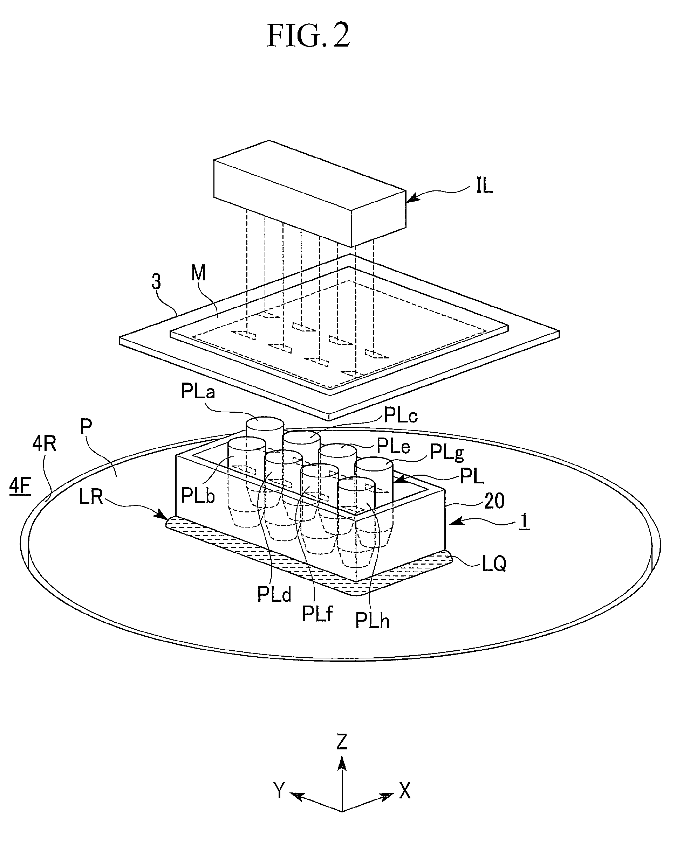

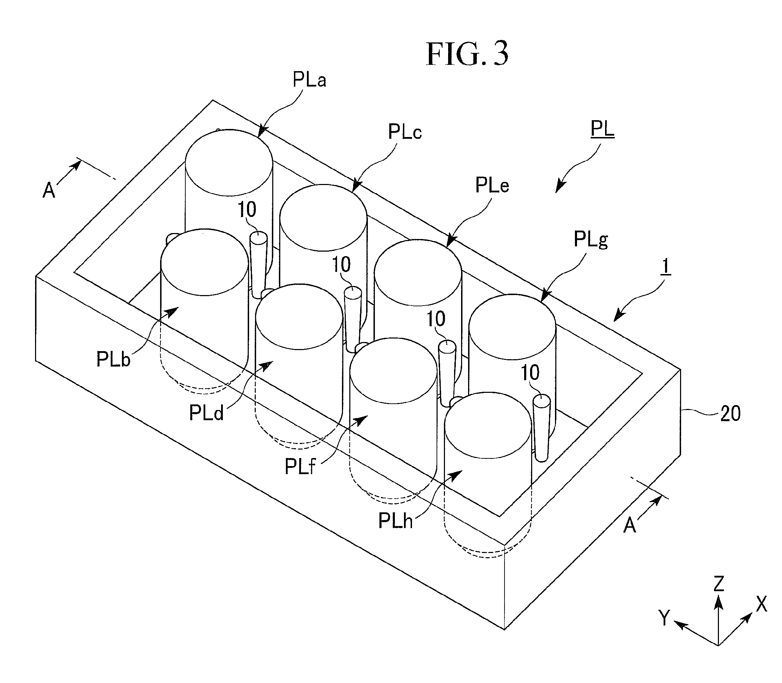

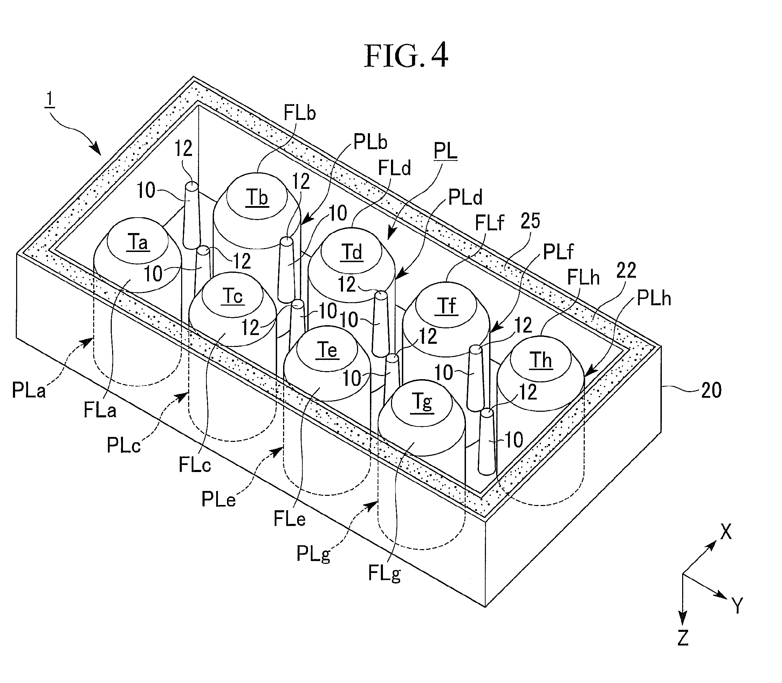

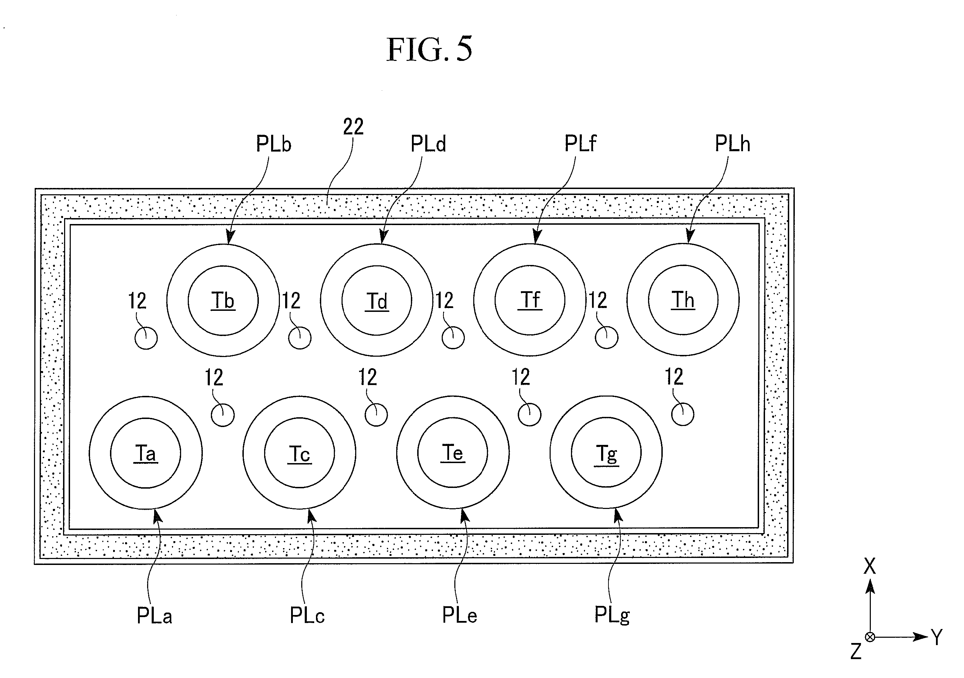

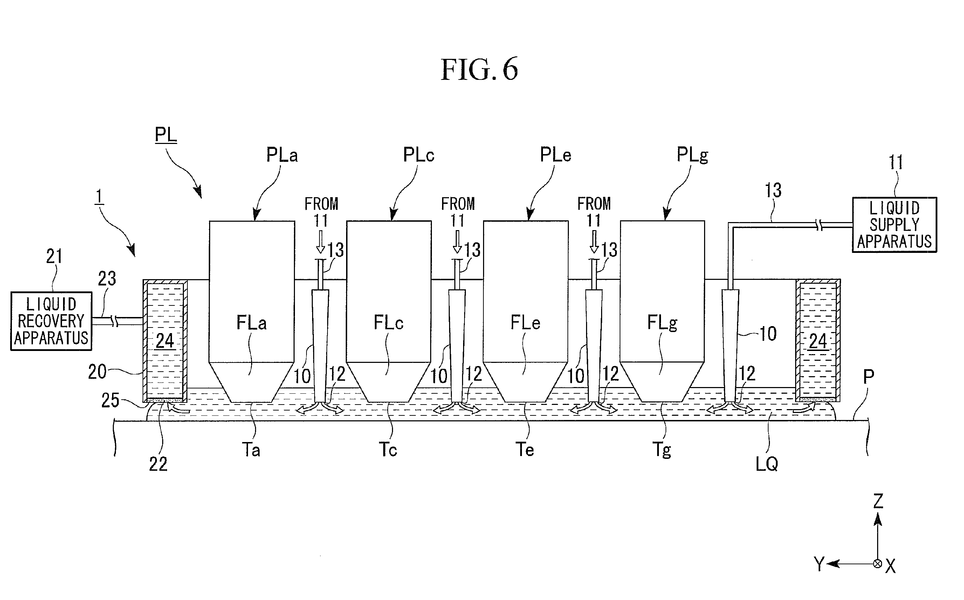

The first embodiment will now be described. FIG. 1 is a schematic structural view showing an exposure apparatus EX according to the first embodiment, while FIG. 2 is a schematic perspective view thereof. FIG. 3 is a perspective view as seen from above of principal portions according to the present embodiment, while FIG 4 is a perspective view thereof as seen from below. FIG. 5 is a plan view thereof as seen from below, while FIG. 6 is a side cross-sectional view showing the schematic structure thereof and corresponds to view taken along a line A-A in FIG. 3.

As is shown in FIGS. 1 and 2, the exposure apparatus EX is provided with a mask stage 3 that is able to move while holding a mask M, a substrate stage 4 that is able to move while holding a substrate P, an illumination system IL that illuminates a mask M held on the mask stage 3 with exposure light EL, a projection system PL that has a plurality of optical elements that are used for irradiating the exposure light EL onto the substrate P and that projects a pattern image of the mask M illuminated by the exposure light EL onto the substrate P, and a control unit 7 that controls overall operations of the exposure apparatus EX.

Note that the term 'substrate' here includes those formed by coating a photosensitive material (i.e., photoresist) onto a substrate such as a semiconductor wafer or the like, and the term 'mask' includes reticles obtained by forming a device pattern in a reduced size projection on a substrate. In addition, in the present embodiment a transmission type mask is used as the mask, however, a reflective type mask may also be used.

The projection system PL is provided with a plurality of projection optical systems PLa to PLh that are arranged in rows. Each of the projection optical systems PLa to PLh projects a pattern image of a mask M that has been illuminated by the exposure light EL onto a substrate P. In the present embodiment, the projection optical system PL is provided with eight projection optical systems PLa to PLh.

In the description given below, the respective eight projections optical systems PLa to PLh of the projection system PL are referred to as first through eighth projection modules PLa to PLh. Moreover, in the description below, when projection modules are described, the description centers principally on the first projection module PLa, however, in the present embodiment the respective projection modules PLa to PLh have substantially the same structure.

The illumination system IL is provided with a plurality of (i.e., eight) illumination optical systems (i.e., illumination modules) corresponding to the number and layout of the plurality of projection modules PLa to PLh of the projection system PL.

In the present embodiment, a description is given using as an example a case in which a scanning exposure apparatus that projects an image of a pattern formed on a mask M onto a substrate P while simultaneously moving the mask M and the substrate P in a scanning direction is used as the exposure apparatus EX. In the description below, the direction of synchronous movement (i.e., the scanning direction) of the mask M and substrate P within a horizontal plane is taken as an X axial direction, a direction within a horizontal plane that is orthogonal to the X axial direction (i.e., a non-scanning direction) is taken as a Y axial direction, and a direction that is perpendicular to the X axial direction and the Y axial direction and is parallel to optical axes of the respective projection modules PLa to PLh is taken as a Z axial direction. Rotation (i.e., tilt) directions around the X axis, Y axis and Z axis are taken respectively as a θX direction, a θY direction, and a θZ direction.

The first projection module PLa has a plurality of optical elements and the plurality of optical elements are held in a lens barrel or the like. As is shown in FIG. 6 and the like, the first projection module PLa is positioned such that a bottom surface Ta of a final optical element FLa that is closest to the image plane of the first projection model PLa faces the substrate P. The bottom surface Ta is a light emission surface from which the exposure light EL is irradiated. In the same way, each of the second through eighth projection modules PLb to PLh is also provided with final optical elements FLb to FLh that have bottom surfaces Tb to Th that are positioned so as to face the surface of the substrate P. Namely, the projection system PL is provided with a plurality of final optical elements FLa to FLh that respectively have bottom surfaces Ta to Th that are positioned so as to face the surface of a substrate P that is held on the substrate stage 4.

The exposure apparatus EX of the present embodiment is a liquid immersion type of exposure apparatus that uses a liquid immersion method in order to substantially widen the depth of focus and improve the resolution by substantially shortening the exposure light wavelength. This exposure apparatus EX is provided with an immersion system 1 in which an area between the surface of the substrate P and the respective bottom surfaces Ta to Th of the plurality of final optical elements FLa to FLh forms an immersion space that is filled with a liquid LQ. The liquid LQ fills the space between the surface of the substrate P and the respective bottom surfaces Ta to Th of the plurality of final optical elements FLa to FLh. In the present embodiment, water (i.e., pure water) is used as the liquid LQ.

In the exposure apparatus EX, an optical path of the exposure light EL between the substrate P and the respective final optical elements FLa to FLh of the projection modules PLa to PLh of the projection system PL is filled with the liquid LQ during at least a time when a pattern image of the mask M is being projected onto the substrate P using the projection system PL. The exposure apparatus EX projects the pattern image of the mask M onto the substrate P and thereby exposes the substrate P by irradiating the exposure light EL that has passed through the mask M via the respective projection modules PLa to PLh of the projection system PL and the liquid LQ onto the substrate P held on the substrate stage 4.

The illumination system IL illuminates a predetermined illumination area on the mask M using the exposure light EL. As is described above, the illumination system IL is provided with a plurality of (i.e., eight) illumination modules corresponding to the number and layout of the plurality of projection modules PLa to PLh of the projection system PL. The illumination system IL illuminates a plurality of illumination areas on the mask M using the exposure light EL that is irradiated from each of the plurality of illumination modules. Note that the illumination system IL includes a light source that generates the exposure light EL, and either one or a plurality (for example, the same number as the number of illumination modules) of light sources may be used. Here, if a number of light sources that is different from the number of illumination modules is provided, the illumination system IL has optical components (i.e., an optical system) that, for example, synthesize the exposure light generated respectively from the plurality of light sources to substantially the same axis, and then divide the synthesized exposure light into a plurality of exposure lights and distribute these to the respective illumination modules. Moreover, as is disclosed, for example, in Japanese Unexamined Patent Application, First Publication No. 2000-260684 (corresponding to United States Patent No. 6,781,672), it is also possible to employ a light source that divides laser light generated from a single laser light source into a plurality of lights and then amplifies each using an amplifier. In this case, the amplifier may be provided not in the light source but in each illumination module.

The exposure light EL that is irradiated from the illumination system IL may be provided, for example, by deep ultraviolet light (DUV light beams) such as emission lines (g-ray, h-ray, i-ray) radiated for example from a mercury lamp and KrF excimer laser beam (having a wavelength of 248 nm), and vacuum ultraviolet light beams (VUV light beams) such as ArF excimer laser beam (having a wavelength of 193 nm) and $F_2$ laser beam (having a wavelength of 157 nm) and the like. In the present embodiment, ArF excimer laser light is used as the exposure light EL.

The mask stage 3 is able to move in the X axial direction, the Y axial direction, and the θZ direction while holding a mask M as a result of being driven by a mask stage driving apparatus 3D that includes an actuator such as a linear motor. Position information on the mask stage 3 (and, consequently, the mask M) is measured using a laser interferometer 3L. The laser interferometer 3L measures the position information of the mask stage 3 using a mobile mirror 3K that is provided on top of the mask stage 3. The control unit 7 drives the mask stage driving apparatus 3D based on measurement results from the laser interferometer 3L, and thereby controls the position of the mask M held on the mask stage 3.

Note that the mobile mirror 3K may be not simply a plane mirror but may also include a corner cube (i.e., a retroreflector). Alternatively, instead of fixing the mobile mirror 3K to the mask stage 3, it is also possible, for example, to use a reflective mirror that is formed by mirror working an end surface (i.e., a side surface) of the mask stage 3. It is also possible for the mask stage 3 to have a structure that allows it to perform coarse and fine movements such as is disclosed, for example, in Japanese Unexamined Patent Application, First Publication No. H08-130179 (corresponding to United States Patent No. 6,721, 034).

The substrate stage 4 has a substrate holder 4H that holds the substrate P. The substrate stage 4 is moveable in a direction of six degrees of freedom of; the X axis, the Y axis, the Z axis, the θX, the θY and the θZ directions on a base component BP, in a condition with the substrate P held on the substrate holder 4H, by means of drive from a substrate stage driving unit 4D which includes an actuator such as a linear motor. The substrate holder 4H is placed in a recessed portion 4R that is provided on the substrate stage 4, and a top surface 4F of the substrate stage 4 excluding the recessed portion 4R is formed as a flat surface having substantially the same height as the surface of a substrate P (i.e., is flush therewith) that is being held in the substrate holder 4H. This is because during, for example, an exposure operation of the substrate P, a portion of either one or a plurality of liquid immersion areas LR (described below) protrudes from the surface of the substrate P and is formed on the top surface 4F. Note that it is also possible for only a portion of the top surface 4F of the substrate stage 4, for example, a predetermined area surrounding the substrate P (including the range to which the liquid immersion area LR protrudes) to be formed at substantially the same height as the surface of the substrate P. If it is also possible to continue filling the optical path space on the image plane side of the projection optical systems PLa to PLh with the liquid LQ (namely, if it is possible to hold the liquid immersion area LR in an excellent condition), then it is also possible for there to be a difference in height between the surface of a substrate P held on the substrate holder 4H and the top surface 4F of the substrate stage 4. Furthermore, it is also possible to form the substrate holder 4H integrally with a portion of the substrate stage 4, however, in the present embodiment, the substrate holder 4H and the substrate stage 4 are formed separately and the substrate holder 4H is fixed in the recessed portion 4R, for example, by vacuum suction or the like.

Position information on the substrate stage 4 (and, consequently, the substrate P) is measured by a laser interferometer 4L. The laser interferometer 4L measures the position information of the substrate stage 4 in the X axial direction, the Y axial direction, and the OZ direction using a mobile mirror 4K that is provided on the substrate stage 4. Surface position information (i.e., position information for the X axial direction, the Y axial direction, and the θZ direction) for the surface of the substrate P that is held on the substrate stage 4 is detected using a focus leveling detection system (not shown). The control unit 7 drives the substrate stage driving apparatus 4D based on measurement results from the laser interferometer 4L and on detection results from the focus leveling detection system, and thereby controls the position of the substrate P held on the substrate stage 4.

Note that it is also possible to employ a structure in which the laser interferometer 4L is able to measure the position in the Z axial direction of the substrate stage 4 and also rotation information in the θX direction and θY direction of the substrate stage 4, and a detailed description thereof is disclosed, for example, in Published Japanese Translation No. 2001-510577 of PCT International Application (corresponding to PCT International Publication No. WO 1999/28790). Furthermore, instead of fixing the mobile mirror 4K to the substrate stage 4, it is also possible, for example, a reflection surface may be used where for example a part of the substrate stage 4 (the side face or the like) is formed by a mirror polishing process.

Moreover, as a result of measuring respective position information in the Z axial direction of the substrate P at a plurality of measurement points, the focus leveling detection system detects tilt information (i.e., and rotation angle) in the θX direction and θY direction of the substrate P, however, it is possible for at least a portion of this plurality of measurement points to be set within the liquid immersion area LR (or projection area), or for all of this plurality of measurement points to be set outside the liquid immersion area LR. Furthermore, if, for example, the laser interferometer 4L is able to measure position information for the substrate P in the Z axial direction, the θX direction and the θY direction, then it is not necessary to provide the focus leveling detection system in order that the position information for the substrate P during an exposure operation in the Z axial direction, and it is possible to control the position of the substrate P in the Z axial direction, the θX direction, and the θY direction using the measurement results from the laser interferometer 4L at least during an exposure operation.

Each of the projection modules PLa to PLh of the present embodiment is a reduction system with a projection magnification of for example 1/4, 1/5, 1/8 or the like, and forms a reduced image of a mask pattern in a projection area that is coupled with the aforementioned illumination area. Note that each of the projection modules PLa to PLh may be either a reduction system, an equalizing system, or a magnification system. Furthermore, each of the projection modules PLa to PLh may be either a dioptric system that does not include any catoptric elements, a catoptric system that does not include any dioptric elements, or a catadioptric system that includes both catoptric elements and dioptric elements. Moreover, each of the projection modules PLa to PLh may form either an inverted image or an erect image.

Next, the projection system PL and the liquid immersion system 1 will be described with reference made to FIGS. 3 through 6.

The projection system PL is provided with the plurality of projection modules PLa to PLh in which the irradiation areas (i.e., the aforementioned projection areas) of the exposure light EL are located separately (i.e., in different positions) in the X direction and Y direction on an XY plane. The plurality of projection modules PLa to PLh are provided so as to be aligned in an X direction and Y direction of an XY plane that is substantially parallel with the surface of the substrate P. Of the plurality of projection modules PLa to PLh, a first group of projection modules PLa, PLc, PLe, and PLg are arranged so as to form a row that runs in the Y axial direction, and a second group of projection modules PLb, PLd, PLf, and PLh are arranged so as to form a row that runs in the Y axial direction. In addition, the row formed by the first group of projection modules PLa, PLc, PLe, and PLg is separated in the X axial direction from the row formed by the second group of projection modules PLb, PLd, PLf, and PLh. The first group of projection modules PLa, PLc, PLe, and PLg is offset by a predetermined amount from the second group of projection modules PLb, PLd, PLf, and PLh, so that the entire layout forms a zigzag pattern. Namely, the row formed by the first group of projection modules PLa, PLc, PLe, and PLg and the row formed by the second group of projection modules PLb, PLd, PLf, and PLh both have a starting point that is offset in the Y axial direction from that of the other row, and are also placed at substantially the same spacing in the Y axial direction. Note that the plurality of projection modules PLa to PLh are not limited to having the above described structure, and a desired structure may be employed provided that the projection areas (i.e., the exposure light irradiation areas) are placed at a predetermined spacing in the Y axial direction.

The bottom surfaces Ta to Th of the projection modules PLa to PLh each have substantially the same height (i.e., are flush). Each of the bottom surfaces Ta to Th is placed so as to face the surface of the substrate P. Exposure light EL that is irradiated in from an object plane side (i.e., the mask M side) of the projection modules PLa to PLh passes through the projection modules PLa to PLh. The exposure light EL that is emitted from the respective bottom surface Ta to Th of the final optical elements PLa to PLh is irradiated onto the substrate P. Each of the plurality of final optical elements FLa to FLh irradiates the exposure light EL onto a predetermined irradiation area.

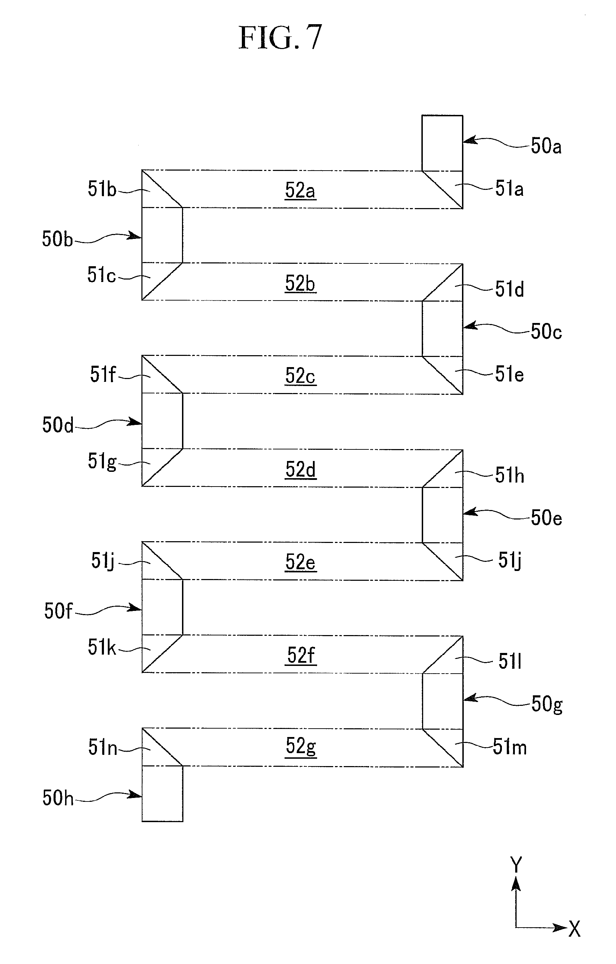

FIG 7 is a plan view showing irradiation areas (i.e., projection areas) 50a to 50h on the substrate P onto which the exposure light EL is irradiated by the projection modules PLa to PLh. The projection areas 50a to 50h correspond to the respective projection areas of each of the projection modules PLa to PLh.

Each of the projection areas 50a to 50h is set having a predetermined configuration (a trapezoidal configuration in the present embodiment). Of the plurality of projection areas 50a to 50h, a first group of projection areas 50a, 50c, 50e, and 50g are arranged so as to form a row that runs in the Y axial direction, and a second group of projection modules 50b, 50d, 50f, and 50h are arranged so as to form a row that runs in the Y axial direction. In addition, the row formed by the first group of projection modules 50a, 50c, 50e, and 50g is separated in the X axial direction from the row formed by the second group of projection modules 50b, 50d, 50f, and 50h. During scanning exposure, of the projection areas 50a to 50h, areas 51a to 51n at the ends of projection areas that are adjacent in the Y axial direction overlap each other (i.e., 51 a and 51b, 51c and 51d, 51e and 51f, 51g and 51h, 51i and 51j, 51k and 511, and 51 m and 51 n) on the substrate, as is shown by the two dot chain line, so as to form overlapping areas (i.e., joining areas) 52a to 52g. Namely, identical areas on a substrate are scan exposed by both one end (for example, 51a) of one projection area of the first group and one end of one projection area of the second group that forms a pair with the one end of the first group.

In this manner, in the present embodiment, respective final optical elements FLa to FLh of a plurality of projection modules PLa to PLh are placed such that areas 51 a to 51n of ends of projection areas 50a to 50h that are adjacent in the Y axial direction overlap. Namely, the respective final optical elements FLa to FLh are placed in positions where end portions of projection areas overlap in the Y axial direction with ends of projection areas of adjacent final optical elements. In addition, the respective final optical elements FLa to FLh are positioned such that projection areas that are adjacent in the Y axial direction are located apart from each other in the X axial direction.

By employing this type of structure, when a substrate P is exposed while the projection modules PLa to PLh are moved relatively to the substrate P in the X axial direction, the accumulated exposure amounts at each position within the scanning exposure range (i.e., within the shot region) on the substrate P become equal. In the projection modules PLa to PLh, because the projection areas 50a to 50h have the above described layout, changes in the optical aberration and changes in illumination in the overlapping areas 52a to 52g can be smoothed.

Returning to FIGS. 3 through 6, the liquid immersion system 1 is provided with supply ports 12 that supply the liquid LQ to the area between the bottom surfaces Ta to Th of the projection modules PLa to PLh and the surface of the substrate P, and a collection port 22 that is used to recover the liquid LQ. In the present embodiment, a plurality of (i.e. eight) supply ports 12 are provided so as to correspond to the plurality of (i.e., eight) projection modules PLa to PLh. The collection port 22 is positioned so as to surround the entire plurality of projection modules PLa to PLh and the plurality of supply ports 12.

Specifically, the liquid immersion system 1 is provided with a plurality of first components 10 that each have a supply port 12, a second component 20 that has the collection port 22, a liquid supply apparatus 11, and a liquid recovery apparatus 21. Each supply port 12 of the plurality of first components 10 is placed between the plurality of projection modules PLa to PLh within the XY plane, and supplies liquid LQ to the space for the optical path of the exposure light EL that is located between the bottom surfaces Ta to Th of the plurality of projection modules PLa to PLh and the surface of the substrate P. The collection port 22 is provided so as to surround the plurality of projection modules PLa to PLh, and recover the liquid LQ from the space for the optical path of the exposure light EL that is located between the bottom surfaces Ta to Th of the plurality of projection modules PLa to PLh and the surface of the substrate P. The liquid supply apparatus 11 supplies the liquid LQ to the supply ports 12 via a supply tube 13 and supply flow paths that are formed inside the first components 10. The liquid recovery apparatus 21 recovers the liquid LQ via the recovery apparatus 22 of the second component 20, a recovery flow path 24 that is formed inside the second component 20, and a recovery tube 23. The supply ports 12 and the supply tube 13 are connected via the supply flow paths. The collection port 22 and the recovery tube 23 are fluidically connected via the recovery flow path 24.

In the present embodiment, a plurality of the first components 10 are arranged in a zigzag pattern so as to correspond to the projection modules PLa to PLh. The supply ports 12 are provided at bottom surfaces of the first components 10 that face the surface of the substrate P.

The second component 20 is provided in a toroidal shape so as to surround the plurality of projection modules PLa to PLh and the plurality of first components 10. The collection port 22 that recovers the liquid LQ is provided at a bottom surface of the second component 20 that faces the surface of the substrate P. In the present embodiment, a porous component (i.e., a mesh) 25 is placed over the collection port 22.

Note that, in the present embodiment, the bottom surfaces Ta to Th of the projection modules PLa to PLh, the bottom surfaces of the first components 10, and the bottom surface of the second component 20 all have substantially the same height (i.e., are all flush).

Note also that it is not a requirement that the bottom surfaces Ta to Th, the bottom surfaces of the first components 10, and the bottom surface of the second component 20 all have the same height and, for example, it is also possible for the bottom surfaces Ta to Th to be placed at a higher position than the bottom surfaces of the first components 10 and the second component 20 (i.e., at a position separated from the surface of the substrate P). Alternatively, it is also possible for the bottom surface of the second component 20 to be placed at a lower position than the bottom surfaces Ta to Th and the bottom surfaces of the first components 10. Moreover, it is not a requirement that the porous component 25 be placed over the collection port 22 and it is also possible, for example, for it to be positioned partway along the recovery flow path of the second component 20.

The liquid supply apparatus 11 is provided with a temperature regulating apparatus that regulates the temperature of the supplied liquid LQ, a degassing apparatus that reduces the vapor component in the liquid LQ, and a filter unit and the like that removes foreign matter from the liquid LQ, and is able to supply a liquid LQ that is clean and temperature-regulated. The liquid recovery apparatus 21 is provided with a vacuum system or the like and is able to recover the liquid LQ.

Next, a method of exposing a substrate P using an exposure apparatus EX having the above described structure will be described.

Operations of a liquid immersion system 1 that includes the liquid supply apparatus 11 and the liquid recovery apparatus 21 are controlled by the control unit 7. The control unit 7 forms a liquid immersion area LR for the liquid LQ on the substrate P using the liquid immersion system 1. As is shown in FIG. 6, the liquid LQ that is fed from the liquid supply apparatus 11 flows through the supply tube 13 and the supply flow paths of the first components 10, and is subsequently supplied onto the substrate P via the supply ports 12. The liquid LQ that is supplied onto the substrate P via the supply ports 12 is supplied to the optical path space for the exposure light EL that is located between the bottom surfaces Ta to Th of the projection modules PLa to PLh and the surface of the substrate P. The liquid LQ supplied through the supply ports 12 spreads over the substrate P between the projection modules PLa and PLh, and forms one liquid immersion area LR on the substrate P that covers the plurality of projection areas 50a to 50h.

The liquid LQ on the substrate P is recovered by the collection port 22 as a result of the liquid recovery apparatus 21 being driven. The liquid LQ from the collection port 22 flows through the recovery flow path 24 of the second component 20, and is then recovered in the liquid recovery apparatus 21 via the recovery tube 23. The control unit 7 controls the liquid immersion system 1 so that liquid supply operations performed by the liquid supply apparatus 11 are conducted in parallel with liquid recovery operations performed by the liquid recovery apparatus 21. As a result, the optical path space for the exposure light EL between the bottom surfaces Ta to Th of the projection modules PLa to PLh and the surface of the substrate P is filled by the liquid LQ, and the one liquid immersion area LR is formed on the substrate P such that the liquid LQ does not leak outside the collection port 22. In the description below, the space between the bottom surfaces Ta to Th of the projection modules PLa to PLh and the substrate P (including the optical path space for the exposure light EL) that is filled by the liquid LQ is also referred to as a "liquid immersion space".

The present embodiment, the liquid immersion system 1 forms a single liquid immersion area LR on the substrate P in order that the area between each of the bottom surfaces Ta to Th of the projection modules PLa to PLh and the surface of the substrate P is filled by the liquid LQ. The liquid immersion area LR is formed locally in a portion of the area on the substrate P so as to cover the plurality of projection areas 50a to 50h.

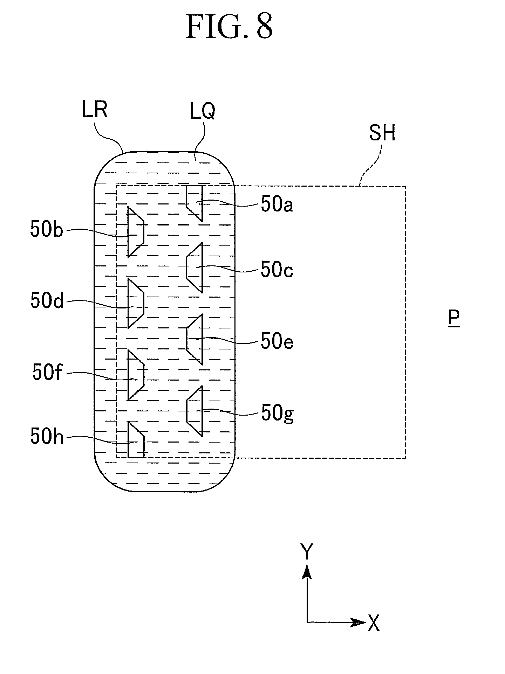

As is described above, the exposure apparatus EX of the present embodiment is a scanning exposure apparatus that exposes the substrate P while moving the projection modules PLa to PLh in the X axial direction relatively to the substrate P. As is shown in typical view in FIG. 8, with the one liquid immersion area LR formed in a portion of the area on the substrate P, the control unit 7 exposes shot areas (i.e., field areas) SH that are set on the substrate P while moving the substrate P in the X axial direction so as to cover the plurality of projection areas 50a to 50h. In the same manner, the control unit 7 sequentially exposes a plurality of shot areas SH on the substrate P.

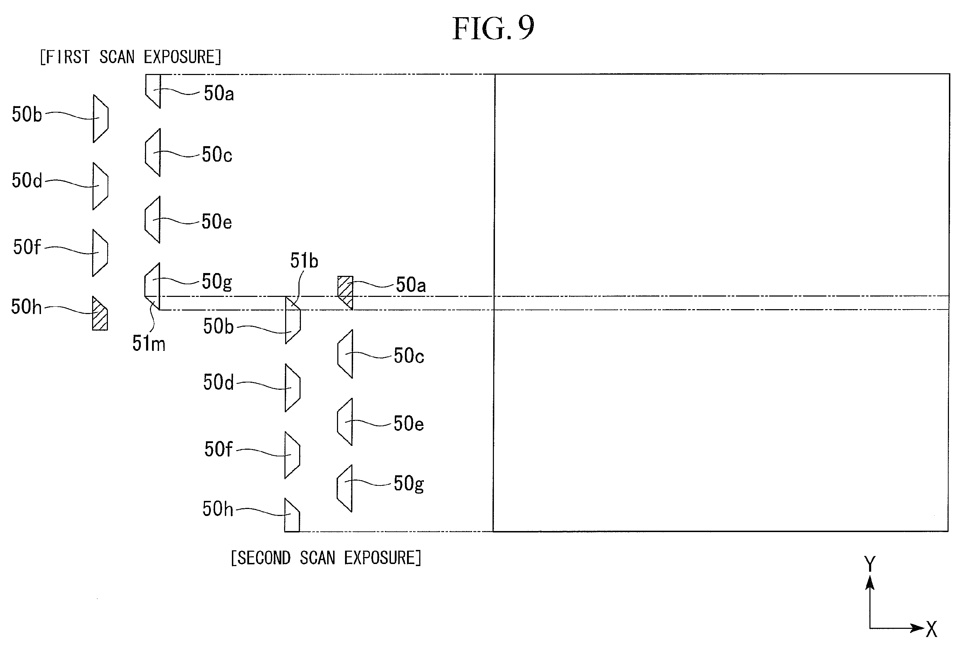

Note that if the size in the Y axial direction of one shot area SH is greater than the distance (also referred to below as the projection width in the Y axial direction) between an end on the +Y side of the projection area 50a and an end on the -Y side of the projection area 50h, then, for example, as is shown in typical view in FIG. 9, by synthesizing a plurality of (two in the present example) pattern images on the substrate P by performing a plurality of (i.e. two) scan exposures, it is possible to expose one shot area SH. When a shot area SH is exposed, as is shown in FIG. 9, the width of the plurality of projection areas 50a to 50h is adjusted in accordance with the size of the shot area SH. In FIG. 9, of the plurality of projection areas 50a to 50h, optical paths corresponding to predetermined projection areas are blocked, for example, by shutters, and exposure is performed such that, in a plurality of scan exposures, ends of the projection areas overlap each other. Specifically, as is shown in FIG. 9, exposure is performed such that an area 51m on the -Y side end of the projection area 50g in a first scan exposure overlaps on the substrate with an area 51b on the +Y side end of the projection area 50b in a second scan exposure. At this time, during the first scan exposure, the projection area 50h is blocked, while during the second scan exposure, the projection area 50a is blocked.

In contrast, if the size in the Y axial direction of one shot area SH is smaller than the aforementioned projection width in the Y axial direction, then the width in the Y axial direction of at least one of the plurality of projection areas 50a to 50h is adjusted using, for example, a field diaphragm or the like, and/or irradiation of the exposure light at a portion of the plurality of projection areas 50a to 50h is prevented using, for example, shutters or the like. This results in the width of the plurality of projection areas 50a to 50h being adjusted (here, narrowed) in accordance with the size of the shot area SH. In this case, in at least one projection module corresponding to the portion of the projection areas where exposure light is not irradiated, it is not necessary to form a liquid immersion space between the bottom surface thereof and the substrate P. Namely, the liquid immersion area LR does not need to cover this portion of the projection areas, however, in the present embodiment, all of the projection areas50a to 50h including this portion of the projection areas are covered by one liquid immersion area LR.

As has been described above, in the present embodiment, because a projection system PL that includes a plurality of projection modules PLa to PLh for irradiating exposure light EL onto a substrate P is provided, and because the substrate P is exposed in a state in which the area between each of the bottom surfaces Ta to Th of the plurality of projection modules PLa to PLh and the surface of the substrate P is filled by the liquid LQ, it is possible to improve resolution while restricting any increase in the size of the optical elements of the respective projection modules PLa to PLh and maintaining excellent optical characteristics in the projection modules PLa to PLh.

If a shot area SH having a predetermined size is exposed using one projection optical system, then if the numerical aperture of the projection optical system is increased in order to achieve an improvement in resolution, there is a possibility that this will lead to an increase in the size of the optical elements of the projection optical system. Large size optical elements a re difficult to manufacture and may lead to increased costs. If, however, the numerical aperture is increased without the size of the optical elements also being increased, then the projection area of one projection optical system (i.e., projection module) is small, and the size of a shot area that can be exposed in one scan exposure is also small. In the present embodiment, because the plurality of projection modules PLa to PLh are provided in rows and liquid immersion exposure is performed on a predetermined shot area SH on a substrate P using the respective projection modules PLa to PLh, it is possible to expose a shot area SH that has the desired size at a high resolution while controlling any increase in the size of the optical elements of the respective projection modules PLa to PLh.

<Second embodiment>

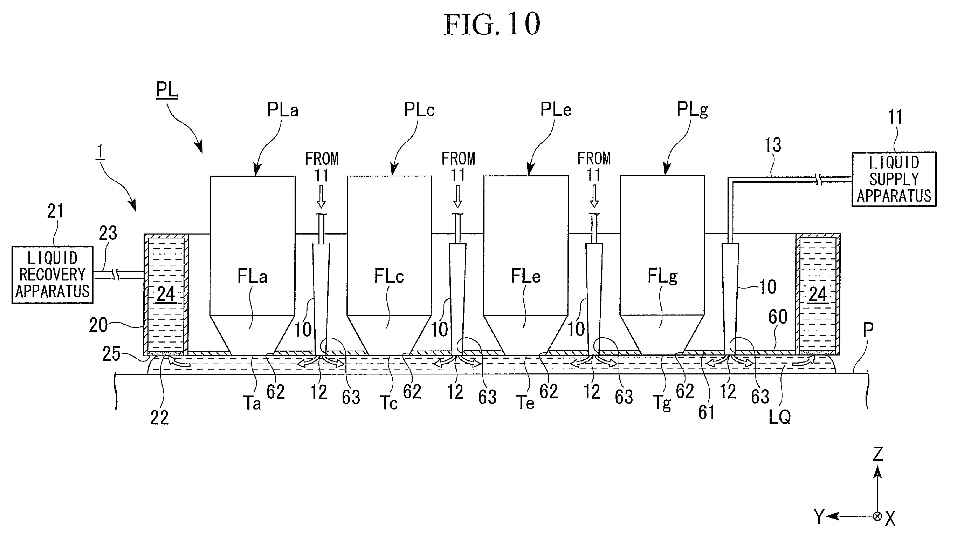

The second embodiment will now be described with reference made to FIG. 10. In the description below, component elements that are the same as or equivalent to those in the above described embodiment are given the same descriptive symbols and any description thereof is either abbreviated or omitted. The second embodiment differs from the above described first embodiment in the structure of the liquid immersion system 1, therefore, the description below concentrates on this difference.

An exposure apparatus EX according to the present embodiment is provided with a plate component 60 that is positioned so as to face the surface of a substrate P between a plurality of projection modules PLa to PLh, and that has a bottom surface 61 that is able to hold liquid LQ between itself and the surface of the substrate P. The bottom surface 61 of the plate component 60 has liquid affinity and is in contact with the liquid LQ that is supplied from supply ports 12. The bottom surface 61 of the plate component 60 is positioned substantially parallel with the surface (i.e., an XY plane) of the substrate P. Holes 62 in which the plurality of projection modules PLa to PLh are able to be placed respectively are provided in the plate component 60. The projection modules PLa to PLh are able to illuminate exposure light EL onto the substrate P via the holes 62 without being obstructed by the plate component 60. In addition, holes 63 in which a plurality of first components 10 are able to be placed respectively are provided in the plate component 60. The supply ports 12 that are provided at bottom surfaces of the first components 10 are able to supply the liquid onto the substrate P via the holes 63.

In the present embodiment, bottom surfaces Ta to Th of the projection modules PLa to PLh, the bottom surfaces of the first components 10, a bottom surface of a second component 20 (i.e., a bottom surface of a mesh component 25), and the bottom surface 61 of the plate component 60 all have substantially the same height (i.e., are all flush). Note that it is not necessary for the bottom surfaces Ta to Th, the bottom surfaces of the first components 10, the bottom surface of the second component 20 and the bottom surface 61 to all have the same height and, for example, it is also possible for the bottom surfaces Ta to Th to be placed at a higher position than the bottom surfaces of the first components 10, the bottom surface of the second component 20, and the bottom surface 61. Alternatively, it is also possible for the bottom surfaces of the first components 10 and the bottom surface 61 to be placed at a higher position than the bottom surfaces Ta to Th and the bottom surface of the second component 20.

The liquid LQ from the supply port 12 is supplied to an optical path space for the exposure light EL that is located between the bottom surfaces Ta to T1 of the projection modules PLa to PLh and the surface of the substrate P, and to a space between the surface of the substrate P and the bottom surface 61 of the plate component 60. The liquid LQ supplied through the supply ports 12 spreads over the substrate P between the projection modules PLa and PLh, and forms a liquid immersion area LR on the substrate P so as to cover the plurality of projection areas 50a to 50h. The liquid LQ that forms the liquid immersion area LR is recovered by a collection port 22 so as not to leak to the outside of the collection port 22.

In this manner, by performing the supply of the liquid LQ through the supply ports 12 in conjunction with the recovery of the liquid LQ through the collection port 22, one liquid immersion area LR is formed on the substrate P.

As has been described above, in the present embodiment, by providing the bottom surface 61 of the plate component 60 that is able to hold the liquid LQ between itself and the surface of the substrate P between the projections modules PLa to PLh, it is possible to hold with stability the liquid LQ that forms the liquid immersion area LR. Moreover, it is possible to control any gas portion (including froth) that might form in the liquid LQ.

Note that, in the second embodiment, the plate component 60 may also be divided into a plurality of components. Moreover, the plate component 60 is formed so as to cover substantially the entire area of the liquid immersion area LR (excluding the projection modules PLa to PLh (i.e., the final optical elements FLa to FLh)), however, it is also possible, for example, for the plate component 60 to be formed in each projection module so as to cover only a predetermined area that surrounds the final optical element thereof. In this case, the supply ports 12 may be provided in the plate component of each projection module, and a collection port that surrounds, for example, the final optical element may be provided in the plate component of each projection module instead of the second component 20 (i.e., the collection port 22), or else in combination therewith.

Note that, in the above described first and second embodiments, the number and placement of the first components 10 (i.e., the supply ports 12) are not limited to those described above, and a variety of modes may be employed as long as the liquid immersion area LR is able to be properly maintained.

Moreover, in the above described first and second embodiments, the collection port 22 does not need to be formed in a rectangular annular shape and may also be formed, for example, in a circular annular shape. It is also possible for a plurality of collection ports 22 to be provided in a dispersed arrangement surrounding the exposure light optical path (i.e., the entire plurality of projection areas) as long as a liquid immersion LR area that does not allow the liquid LQ to leak can be maintained.

Furthermore, as is disclosed in, for example, Japanese Unexamined Patent Application, First Publication No. 2004-289126 (corresponding to US Patent Publication No. 2004/0165159), it is also possible to place a gas sealing mechanism (i.e., a gas curtain mechanism) that blows out a predetermined gas (i.e., air or nitrogen) in at least a portion of the periphery of the collection port 22 so that any outflow of the liquid LQ to the outside (i.e., the periphery) of the collection port 22 is even more reliably controlled.

<Third embodiment>

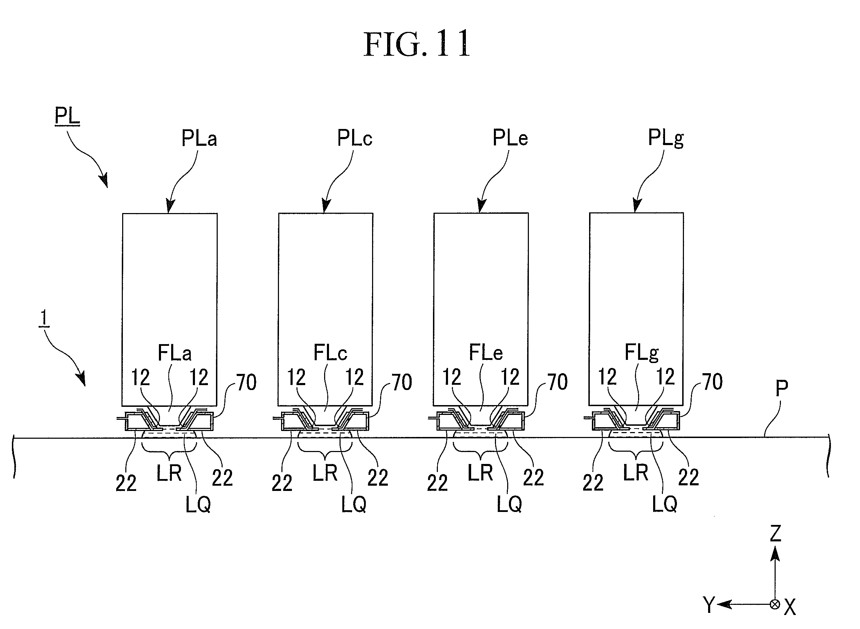

The third embodiment will now be described with reference made to FIGS. 11 through 13. In the description below, component elements that are the same as or equivalent to those in the above described embodiments are given the same descriptive symbols and any description thereof is either abbreviated or omitted. The third embodiment differs from the above described embodiments in the structure of the liquid immersion system 1, therefore, the description below concentrates on this difference.

The liquid immersion system 1 of the present embodiment has a plurality of supply ports 12 that correspond to each of the plurality of projection modules PLa to PLh, and a plurality of collection ports 22 that correspond to each of the plurality of projection modules PLa to PLh. The supply ports 12 and the collection ports 22 are provided in nozzle components 70. The nozzle components 70 are provided corresponding to each projection module PLa to PLh in the vicinity of the respective optical paths of the exposure light EL between the final optical elements FLa to FLh and the substrate P.

In the liquid immersion system 1 of the present embodiment, a plurality of liquid immersion areas LR are formed on the substrate P such that spaces between each of the plurality of projection modules PLa to PLh and the substrate P are filled with the liquid LQ.

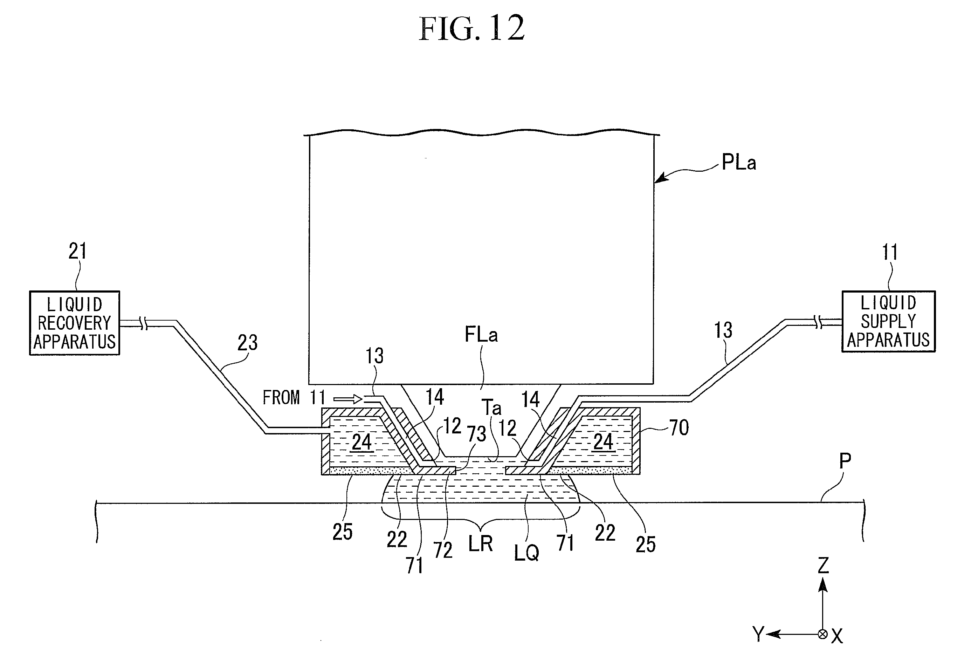

FIG. 12 is a view showing a nozzle component 70 that is provided for the first projection module PLa. In FIG. 12, the nozzle component 70 is provided in a annular shape so as to surround the optical path of the exposure light EL. The supply ports 12 that supply the liquid LQ are provided on an inner side surface (i.e., sloping surface of which at least a portion faces a side surface of a final optical element) of the nozzle component 70 that faces the optical path of the exposure light EL. The collection ports 22 that recover the liquid LQ are provided on a bottom surface of the nozzle component 70 that faces the surface (i.e., the XY plane) of the substrate P. A mesh component (i.e., a porous component) 25 is placed on each collection port 22.

In the present embodiment, the nozzle component 70 has a bottom plate 72 that is placed between the bottom surface Ta of the final optical element FLa and the surface of the substrate P. The bottom plate 72 is provided in order that the final optical elements do not touch the substrate P. An aperture 73 through which the exposure light EL is passed is also provided in the bottom plate 72.

A bottom surface 71 of the nozzle component 70 includes a bottom surface of the bottom plate 72 and a bottom surface of the mesh component 25. The bottom surface 71 of the nozzle component 70 that includes the bottom surface of the bottom plate 72 and the bottom surface of the mesh component 25 is positioned so as to face the surface (i.e., the XY plane) of the substrate P and is able to hold the liquid LQ between itself and the surface of the substrate P.

Supply flow paths 14 that fluidically connect the supply ports 12 to the supply tubes 13 are formed inside the nozzle component 70. Recovery flow paths 24 that fluidically connect the collection ports 22 to a recovery tube 23 are also formed inside the nozzle component 70.

The liquid LQ that is fed from the liquid supply apparatus 11 flows through the supply tubes 13 and the supply flow paths 14 of the nozzle component 70, and is then supplied through the supply ports 12 to the optical path (i.e., space) of the exposure light EL via the space between the bottom surface Ta of the final optical element FLa and the top surface of the bottom plate 72. The liquid LQ is also recovered through the collection ports 22 as a result of the liquid recovery apparatus 21 being driven. After the liquid LQ from the collection ports 22 has flowed through the recovery flow paths 24 of the nozzle component 70, it is recovered to the liquid recovery apparatus 21 via the recovery tube 23. The control unit 7 controls the liquid immersion system 1 such that the operation to supply the liquid LQ that is performed by the liquid supply apparatus 11 is conducted in parallel with the operation to recover the liquid LQ that is performed by the liquid recovery apparatus 21. As a result, the liquid immersion area LR of the liquid LQ is formed locally on a portion of the substrate P such that the optical path of the exposure light EL between the final optical element FLa and the substrate P is filled with the liquid LQ (i.e., a liquid immersion space (that includes the optical path space of the exposure light EL) that becomes filled with the liquid LQ is formed between the final optical elements FLa and the substrate P).

One of the nozzle component 70 shown in FIG. 12 is provided for each of the projection modules PLa to PLh. In the liquid immersion system 1, a plurality of liquid immersion areas LR are formed on the substrate P using the respective nozzle components 70 such that the spaces between the plurality of projection modules PLa to PLh and the substrate P are filled with the liquid LQ.

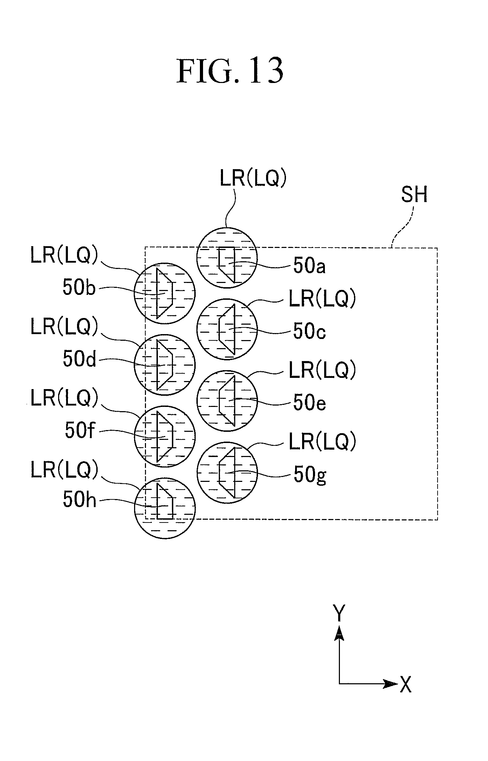

As is shown in typical view in FIG. 13, with a plurality of (i.e., eight) liquid immersion areas LR formed on the substrate P, the liquid immersion system 1 exposes shot areas (i.e., field areas) SH that are set on the substrate P while moving the substrate P in the X axial direction so as to individually cover the plurality of projection areas 50a to 50h.

As is described above, in the present embodiment, because a plurality of liquid immersion areas LR are provided so as to correspond to the plurality of projection modules PLa to PLh, it is possible to reduce the quantity of the liquid LQ that is used in order to cover the plurality of projection areas 50a to 50h with the liquid LQ.

Note that the structure of the respective nozzle components 70 is not limited to that shown in FIG. 12 and a variety of structures may be employed. For example, nozzle components (i.e., liquid immersion systems) such as those disclosed in European Patent Publication No. EP 1,420,298, PCT International Patent Publication Nos. WO 2004/055803, WO 2004/057590, WO 2005/029559, WO 2004/086468 (corresponding to U.S. Patent Publication No. 2005/0280791A1), and Japanese Unexamined Patent Application, First Publication No.

2004-289126 (corresponding to United State Patent No. 6,952,253) may be used. As an example, the nozzle components 70 (i.e., the liquid immersion system 1) may be provided with a gas sealing mechanism (i.e., a gas skirt mechanism) that blows out a predetermined gas (i.e., air or nitrogen), as is disclosed, for example, in Japanese Unexamined Patent Application, First Publication No. 2004-289126 (corresponding to U.S. Patent Publication No. 2004/0165159). It is also possible for the nozzle components 70 to also supply the liquid LQ to the incident surface side of the final optical elements of the projection modules and to also form liquid immersion spaces between the final optical elements and the optical elements that are positioned facing the final optical elements. Note that, in the above described first and second embodiments as well, it is also possible to employ a liquid immersion system in which liquid immersion spaces are formed not only on the emission surface side of the final optical elements, but also on the incident side thereof.

In the present embodiment, it is also possible to provide a collection port 22 such as that shown in the first embodiment that surrounds the plurality if projection modules PLa to PLh, and thereby recover the liquid LQ that was not recovered by the respective nozzle components 70.

Note that, in the present embodiment, a structure is employed in which a liquid immersion area LR is formed respectively in each of the plurality of projection modules PLa to PLh, however, when, for example, a portion of the plurality of projection modules PLa to PLh are not used during an exposure, then it is not necessary to form liquid immersion areas in that portion of the projection modules. Namely, it is only necessary to form liquid immersion areas in at least a portion of the plurality of projection modules PLa to PLh that are used during an exposure (i.e., through which the exposure light IL passes).

<Fourth embodiment>

Next, the fourth embodiment will be described. In the above described first through third embodiments, water (i.e., pure water) is used as the liquid LQ, however, it is also possible to use a liquid LQ having a refractive index relative to the exposure light EL that is higher than that of pure water (whose refractive index is approximately 1.44), for example, 1.5 or more. In the present embodiment, an improvement in resolution can be achieved by using a liquid LQ that has this type of high refractive index. Note that the exposure apparatus according to the present embodiment may be any of the exposure apparatuses of the above described first through third embodiments.

In order to simplify the description given below, a refractive index of the final optical elements relative to the exposure light EL is suitably referred to as the refractive index $n_1$ of the final optical elements, while a refractive index of the liquid LQ relative to the exposure light EL is suitably referred to as the refractive index $n_2$ of the liquid LQ.

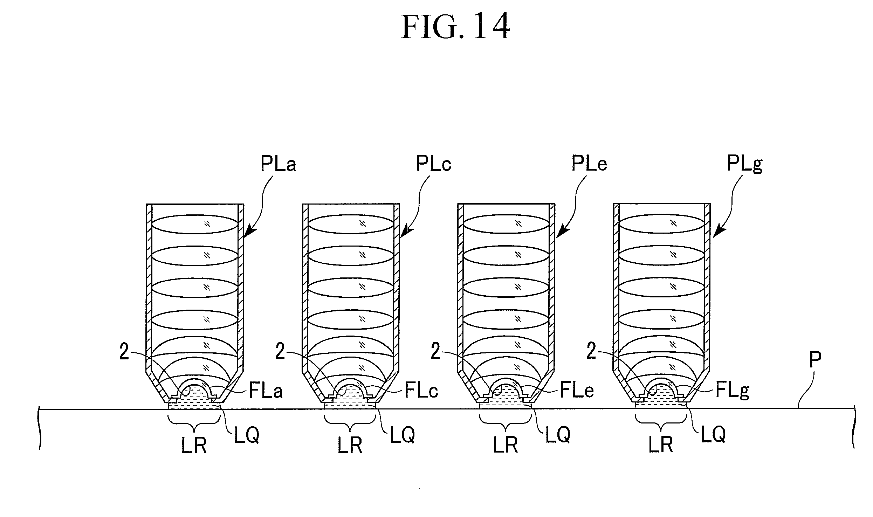

When the refractive index $n_2$ of the liquid LQ relative to the exposure light EL (i.e., ArF excimer laser beam: wavelength 193 nm) is greater than the refractive $n_1$ of the final optical elements relative to the exposure light EL, and when the numerical aperture NA of the projection modules is also greater than or equal to the refractive index $n_1$ of the final optical elements, namely, when

$$n_2 > NA \geqq n_1, \ \dots (1)$$

then, as is shown in FIG. 14, it is desirable for the shape of the surfaces on the + Z side (i.e., the object plane side) of the final optical elements FLa to FLh to be set as convex shapes that protrude towards the object plane side (i.e., the mask side) of the projection optical system PL (i.e., the projection modules PLa to PLh), and for the shape of the surfaces on the - Z side (i.e., the image plane side) of the final optical elements FLa to FLh to be set as concave surfaces 2 that curve inwards so as to move away from the substrate P. Note that the curved surface shape of the final optical elements may be appropriately set in order to obtain the desired characteristics from the projection modules, and may be set as a spherical shape or as a non-spherical shape.

When the refractive index $n_2$ of the liquid LQ relative to the exposure light EL is greater than the refractive $n_1$ of the final optical elements relative to the exposure light EL, and when the numerical aperture NA of the projection optical system PL (i.e., the projection modules PLa to PLh) is greater than to the refractive index n1 of the final optical elements relative to the exposure light EL, then by providing the concave surfaces 2 the exposure light EL can be made to reach the substrate P in an excellent condition.

Examples of the liquid LQ include predetermined liquids having C-H bonds or O-H bonds such as isopropanol having a refractive index of approximately 1.50, and glycerol (glycerin) having a refractive index of approximately 1.61, or predetermined liquids (organic solvents) such as hexane, heptane, and decane. Alternatively, it is also possible to use a liquid obtained by combining an optional two or more types of these predetermined liquids, or to use pure water to which the above described predetermined liquids have been added (or mixed). Alternatively, a liquid obtained by adding (or mixing) a base or acid such as $H^+$, $Cs^+$, $K^+$, $Cl^-$, $SO_4^{2-}$, and $PO_4^{2-}$ to pure water may be used as the liquid LQ. Furthermore, a liquid obtained by adding (or mixing) fine particles of a substance such as Al oxide to pure water may be used as the liquid LQ. These liquids LQ allow ArF excimer laser beam to transit through. It is also preferable for a liquid that has a low light absorption coefficient, a low temperature dependency, and exhibits stable behavior towards a photosensitive material (or a protective film (i.e. a top coating film) or an anti-reflective film or the like) that s coated on the projection modules PLa to PLh and/or on the surface of the substrate P to be used for the liquid LQ.

The final optical elements may be formed from, for example, quartz (i.e., silica). Alternatively, they may be formed from monocrystalline fluorine compounds such as calcium fluoride (i.e., fluorite), barium fluoride, strontium fluoride, lithium fluoride and sodium fluoride. The optical elements may also be formed from the above described materials. It is also possible, for example, for at least a portion of or all of the optical elements excluding the final optical elements from among the plurality of optical elements of the projection modules to be formed from fluorite, or for the final optical elements to be formed from quartz, or for a portion of or all of the optical elements excluding the final optical elements to be formed from quartz, or for the final optical elements to be formed from fluorite, or for all of the optical elements of the projection modules to be formed from quartz (or fluorite).

For example, when the final optical elements are formed from quartz (i.e., synthetic quartz), because the refractive index of the quartz is approximately 1.5, a liquid having a refractive index higher than the refractive index of quartz, for example, approximately 1.6 to 1.8 is used for the liquid LQ.

It is also possible for at least one of the optical elements of the projection modules to be formed from a material having a higher refractive index than quartz and/or fluorite. For example, it is also possible to use a projection module (i.e., a projection optical system) having a final optical elements that has a refractive index relative to the exposure light EL of 1.6 or more. Examples of a material having a refractive index of 1.6 or more that may be used to form the final optical elements or the like include sapphire and germanium dioxide such as are disclosed in PCT International Patent Publication No. WO 2005/059617, or potassium chloride (refractive index: approximately 1.75) or the like as is disclosed in International Patent Publication No. WO 2005/059618.

By using final optical elements that have a high refractive index, it is possible to make the refractive index $n_2$ of the liquid LQ greater than the numerical aperture of the projection module, and make the refractive index $n_1$ of the final optical elements greater than the refractive index $n_2$ of the liquid LQ. Namely, it is possible to make

$$n_1 > n_2 > NA. \quad \ldots (2)$$

In addition, by using a liquid LQ having a refractive index of 1.5 or more and by using a final optical element having a refractive index of 1.6 or more, it is possible to achieve an improvement in resolution, and a reduction in the size of the projection modules (i.e., the projection optical system).

When Formula (2) above is valid, then even if the final optical elements do not have a concave surface, the exposure light EL can be made to reach the substrate P. In addition, by using final optical elements that have a high refractive index and a liquid LQ that has a high refractive index, then when, such as in FIG 8 and the like, a predetermined shot area SH having a width in the Y axial direction of, for example, approximately 30 mm is exposed, it is possible to reduce the size of the diameter of the final optical elements to, for example, approximately 5 mm. It is also possible to make the size in the Y axial direction of the collection port 22 approximately 30 mm.

Note that, in each of the above described embodiments, the projection areas 50a to 50h of the plurality of projection modules PLa to PLh are divided into a first group and a second group, and the plurality of projection areas of each group are aligned in a row in parallel with the Y axial direction on an XY plane, however, the layout of the plurality of projection areas is not limited to this. For example, the projection areas 50a to 50h may be divided into three or more groups and these three or more groups may be arranged apart from each other in the X axial direction. In this case, in the same way as in each of the above described embodiments, it is preferable for the positions in the Y axial direction of all of the projection areas to be to be different. It is also possible for the rows that are made up of the plurality of projection areas of each group to intersect the Y axial direction, in other words, parallel with a direction that intersects the X axial direction. Furthermore, it is not necessary for the plurality of projection areas of each group to be arranged in one row, and if, for example, the aforementioned row is parallel with the Y axial direction, then a portion of or all of the plurality of projection areas making up this row may be in a different position in the X axial direction. In other words, the plurality of projection areas may be positioned at predetermined intervals in the Y axial direction. It is also possible for the projection areas of the plurality of projection modules to not be divided into a plurality of groups, and for the plurality of projection areas to be positioned at predetermined intervals in the Y axial direction, for example, be aligned in a single row parallel with the Y axial direction. In this case, an entire one shot area on a substrate can be exposed by performing at least two scan exposures. For example, if the interval in the Y axial direction of the plurality of projection areas is set as equal to the width in the Y axial direction of one projection area, then an entire one shot area on a substrate is exposed by a first scan exposure in which the substrate is moved in the +X axial direction and a second scan exposure in which the substrate is moved in the -X axial direction. Here, the substrate is moved in the Y axial direction by a predetermined distance that corresponds to the interval between the projection areas after the ending of the first scan exposure and prior to the starting of the second scan exposure.

Moreover, in each of the above described embodiments, the projection areas of the projection modules have a trapezoidal shape, however, they may also have another shape such as, for example, a parallelogram shape, a diamond shape, and a rectangular shape. Here, if the projection areas are formed having a rectangular shape, then it is preferable that the exposure light intensity is gradually changed is gradually changed at end portions of the projection areas such that the exposure light intensity distribution in the Y axial direction in the projection areas has a sloped portion at both ends thereof.

Furthermore, in each of the above described embodiments, the exposure apparatus is provided with the entire liquid immersion system 1, however, it is not essential for the exposure apparatus to be provided with a portion of the liquid immersion system 1 (for example, the components constituting the liquid supply apparatus 11 and/or the liquid recovery apparatus 21), and these may be substituted, for example, by equipment in the factory or the like where the exposure apparatus is installed.

Note that, in each of the above described embodiments, for example, the position and/or the tilt in the Z axial direction of the projection plane (i.e., image formation plane) on which a pattern image of a mask is created may be different in at least a portion of the plurality of projection modules as a result of bending of the mask that is caused by the weight of the mask itself. Therefore, during a scan exposure, based on image plane information (i.e., Z position and tilt information of the image formation plane) of the plurality of projection modules, and on surface information of the substrate (i.e., Z position and tilt information of the surface thereof), the relative positional relationship between the substrate and at least one of the image formation planes of the plurality of projection modules is adjusted in at least one of the Z axial direction, the θx direction, and the θy direction. As a result, during a scan exposure, the image formation plane and the surface of the substrate substantially match within the projection area of each projection module (i.e., the surface of the substrate is set within the range of the depth of focus thereof).

Here, the positional relationship between the image formation plane and the substrate is adjusted by moving (including tilting) the image formation plane of the projection module and/or the substrate. The movement of the image formation plane is conducted, for example, by performing at least one of: (1) moving at least one optical element of the projection module; (2) altering the wavelength and/or spectrum width (i.e., full width at half maximum (FWHM) or E 95% width or the like) of the exposure light; or (3) altering the refractive index of the medium (fluid) relative to the exposure light within a predetermined space through which the exposure light passes. The movement of the substrate is achieved, for example, using the substrate stage.

The medium (fluid) in (3) above may be atmospheric air (i.e., air) or else a gas that does not cause the exposure light to be attenuated to any degree (for example, a purge gas such as nitrogen or helium), however, in the each of the above described embodiment, it may also be the liquid (LQ) used for the liquid immersion. In this case, the refractive index of the liquid is adjusted by, for example, altering the temperature, pressure, or composition (i.e., type or combination) of the liquid within the aforementioned liquid immersion space. When, as is described above, a liquid immersion space is formed on both the emission side and incident side of the final optical elements, the refractive index of the liquid may be adjusted in either one or in both of these two liquid immersion spaces.

Moreover, when there is a sizable difference in the Z position and/or tilt of the image formation plane in at least a portion of the plurality of projection modules, or when a predetermined allowable range thereof is exceeded, then it is preferable for the Z position and/or tilt of the image formation plane of at least one projection module to be adjusted prior to exposure, so that the Z positions and/or tilt of the image formation planes are made uniform in the plurality of projection modules (i.e., are made uniform within the predetermined allowable range). In this case, it is also possible to adjust the Z position and/or tilt of this image formation plane by altering the refractive index of the liquid within the aforementioned liquid immersion space in at least one of the plurality of projection modules in accordance, for example, with the bending information of the mask. The refractive index of the liquid used for liquid immersion is altered by adjusting the temperature or altering the composition, or the like of the immersion liquid, however, this altering of the composition includes, for example, altering the immersion liquid to another type of liquid (including liquids to which predetermined substances have been added), and, if the immersion liquid is a combination of two or more types of liquid, altering the combination of liquids and/or altering the mixture ratios thereof.

Furthermore, in the exposure apparatuses in each of the above described embodiments, a mask is placed in an upwards position (i.e., on the + Z side) relative to the projection optical system (i.e., the plurality of projection modules), and the substrate is placed in a downwards position (i.e., on the - Z side) relative thereto, however, as is disclosed, for example, in International Patent Publication No. WO 2004/090956 (corresponding to U.S. Patent Publication No. 2006/0023188A1), it is also possible to provide the projection optical system (i.e., the plurality of projection modules) in a vertically inverted state relative to the vertical direction (i.e., the Z axial direction) in FIG. 1, and place the mask on the downward (i.e., - Z side) thereof.

In each of the above described embodiments, position information on the mask stage and substrate stage is measured using an interferometer system, however, the present invention is not limited to this and, for example, it is also possible to use an encoder system that detects a scale (i.e., a diffraction grating) that is provided on a top surface of the substrate stage. In this case, it is preferable to use a hybrid system that is provided with both an interferometer system and an encoder system, and to calibrate the measurement results from the encoder system using the measurement results from the interferometer system. It is also possible to control the position of the substrate stage by alternately switching between using an interferometer system and an encoder system, or by using both together.

Moreover, in each of the above described embodiments, ArF excimer laser light beam is used as the exposure light EL, however, as is described above, it is possible to use various types of exposure light (i.e., exposure beams) such as $F_2$ laser light beam. Here, instead of an ArF excimer laser, as is disclosed in PCT International Publication No. WO 1999/46835 (corresponding to United State Patent No. 7,023,610), it is possible to use a harmonic generator that includes a sold state laser light source such as a DFB semiconductor laser or a fiber laser, an optical amplifier having a fiber amp or the like, and a wavelength converter and the like, and that outputs pulse light having a wavelength of 193 nm. The most appropriate liquid LQ that fills the optical path can be selected in accordance with wavelength of the exposure light (i.e., the exposure beams) EL, the numerical aperture of the projection optical system PL (i.e., the projection modules PLa to PLh), and the refractive index of the final optical elements relative to the exposure light EL, and the like.

The substrate P that is used in each of the above described embodiments may be not only a semiconductor wafer that is used for manufacturing semiconductor devices, but may also be a glass substrate for a display device, a ceramic wafer for a thin film magnetic head, or an original plate (i.e., synthetic quartz or silicon wafer) for a mask or reticle that is used in an exposure apparatus, and the like. Moreover, the shape of the substrate is not limited to a circular shape, but may also be another shape such as a rectangular shape.

The exposure apparatus EX may be not only a step-and-scan type of scanning exposure apparatus (i.e., a scanning stepper) that scan exposes a pattern of a mask M while simultaneously moving the mask M and the substrate P, but may also be a step-and-repeat type of projection exposure apparatus (i.e., a stepper) that makes a comprehensive exposure of a pattern on the mask M while the mask M and the substrate P are both stationary and then moves the substrate P in sequential steps.

As the exposure apparatus EX it is also possible to use a type of exposure apparatus that, with a first pattern and the substrate P in a substantially stationary state, comprehensively exposes a reduced image of the first pattern on the substrate P using a projection optical system (for example, a dioptric projection optical system that does not include catoptric elements at a reduction factor of 1/8). In this case, it is possible to subsequently use a stitch type of comprehensive exposure apparatus that, with a second pattern and the substrate P in a substantially stationary state, comprehensively exposes a reduced image of the second pattern using this projection optical system so as to overlap portions of the first pattern. This stitch type of exposure apparatus may be a step-and-stitch type of exposure apparatus that moves the substrate P in sequence while transferring at least two patterns onto the substrate P such that they partially overlap.

In each of the above described embodiments, an example of an exposure apparatus that is provided with a projection optical system is described, however, the present invention can also be applied to an exposure apparatus and exposure methods that do not use a projection optical system. Even if a projection optical system is not used, exposure light is irradiated onto a substrate via optical components such as a mask or lens, and a liquid immersion area is formed in a predetermined space between such optical components and the substrate.

The present invention can also be applied to a twin stage type of exposure apparatus that is provided with a plurality of substrate stages such as is disclosed, for example, in Japanese Unexamined Patent Application, First Publication Nos. H10-163099 and H10-214783 (corresponding to United State Patent No. 6,590,634), Published Japanese Translation No. 2000-505958 of the PCT International Application (corresponding to United State Patent No. 5,969,441), United State Patent No. 6,208,407, and the like.

Furthermore, the present invention can also be applied to an exposure apparatus that is provided with a substrate stage that holds a substrate, and a measurement stage on which are mounted reference components on which reference marks are formed and/or various types of electro-optic sensors such as is disclosed, for example, in Japanese Unexamined Patent Application, First Publication No. H11-135400 (corresponding to PCT International Publication No. WO 1999/23692) and Japanese Unexamined Patent Application, First Publication No. 2000-164504 (corresponding to United State Patent No. 6,897,963) and the like.

In the above described embodiments, the liquid that fills the space between the projection optical system PL (i.e., the projection optical modules PLa to PLh) and the substrate P covers localized portions of the surface of the substrate P, however, the present invention can also be applied to liquid immersion exposure apparatuses that perform exposure with the entire surface of the substrate that is being exposed immersed in a liquid, such as are disclosed, for example, in Japanese Unexamined Patent Application, First Publication Nos. H06-124873 and H10-303114, and United State Patent No. 5,825,043.

The type of exposure apparatus EX that is used is not limited to an exposure apparatus for manufacturing semiconductor elements that exposes a semiconductor element pattern on a substrate P, and it is also possible to use a broad range of exposure apparatuses and the like such as exposure apparatuses for manufacturing liquid crystal display elements or display units, and exposure apparatuses for manufacturing thin film magnetic heads, image pickup elements (CCD), micro machines, MEMS, DNA chips, or reticles and masks.

In the above described embodiments, an optically transparent mask that is obtained by forming a predetermined light shield pattern (or phase pattern or reduced light pattern) on an optically transparent substrate is used, however, instead of this mask, as is disclosed in United State Patent No. 6,778,257, it is also possible to use a transmitting pattern or reflective pattern based on electronic data of the pattern to be exposed, or an electronic mask that forms a light emitting pattern (also known as a variable molding mask which includes, for example, digital micro-mirror devices (DMD) which are a type of non-light emitting image display element (spatial optical modulators)).

For example, by forming a pattern using reflective elements such as DMD, it is possible to form a predetermined pattern on a substrate without using a mask, and to thereby reduce manufacturing costs. Note that if a DMD is used, the respective projection magnifications of the projection modules PLa to PLh may be set, for example to 1/100. Moreover, in an exposure apparatus that uses a DMD, during a scan exposure it is possible for only the substrate to be moved.

Moreover, as is disclosed, for example, in PCT International Patent Publication No. WO 2001/035168, the present invention can also be applied to an exposure apparatus (i.e., a lithography system) that exposes a line and space pattern on a substrate P by forming an interference fringe on the substrate P.

Furthermore, the present invention can also be applied to exposure apparatuses that, as is disclosed, for example, in Published Japanese Translation No. 2004-519850 of the PCT International Application (corresponding to United State Patent No. 6,611,316), synthesize two mask patterns on a substrate via a projection optical system and perform a double exposure substantially simultaneously of one shot area on a substrate using one scan exposure.

As far as permitted, it should be understood that all of the publicly available information and United States Patent disclosures relating to exposure apparatuses that have been cited in each of the above described embodiments and variant examples have been incorporated in the description of the present application.

As is described above, in the exposure apparatus EX of the embodiments, the various subsystems including the respective component elements are assembled so as to maintain a predetermined mechanical accuracy, electrical accuracy, and optical accuracy. In order to secure these different accuracies, after assembly, adjustments are made in order to achieve optical accuracy in the respective optical systems. Adjustments are also made in order to achieve mechanical accuracy in the respective mechanical systems, and adjustments are also made in order to achieve electrical accuracy in the respective electrical systems. The process to assemble an exposure apparatus from the various subsystems includes making mechanical connections, electrical circuit wiring connections, and barometric circuit *tube* connections between the various subsystems. It is to be understood that, prior to the process to assemble an exposure apparatus from these various subsystems, there are also processes to assemble each of the individual subsystems. After the process to assemble an exposure apparatus from the various subsystems, overall adjustments are made so that the various accuracies of the overall exposure apparatus are secured. Note that it is desirable for an exposure apparatus to be manufactured in clean room where the temperature and cleanliness are controlled.

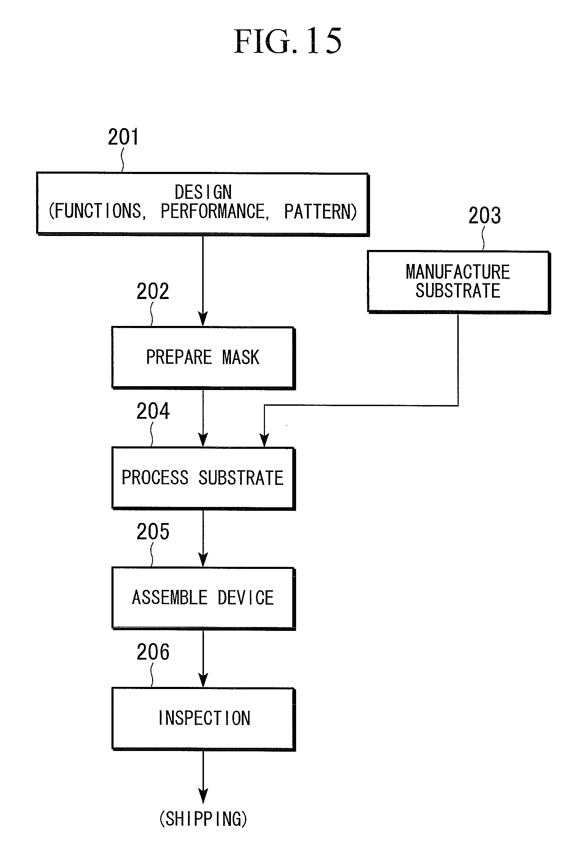

As is shown in FIG. 15, a micro device such as a semiconductor device is manufactured via a step 201 in which the functions and performance of the micro device are designed, a step 202 in which a mask (reticle) is prepared based on the design step, a step 203 in which a substrate is manufactured as the base material of the device, a step 204 that includes substrate processing such as: a step of exposing the pattern on the mask onto the substrate using the exposure apparatus EX of the above described embodiment; a step of developing the exposed substrate; and a step of heating (i.e., curing) and etching the developed substrate, a step 205 in which the device is assembled (including working steps such as a dicing step, a bonding step, and a packaging step), and an inspection step 206 and the like.

INDUSTRIAL APPLICABILITY

According to the present invention, it is possible to restrict any increase in the size of the optical components and achieve an improvement in resolution, and it is possible to achieve an excellent exposure of a substrate.

**Claims**

1. An exposure apparatus that exposes a substrate via a liquid using exposure light, comprising:

    an optical system having a plurality of optical members, the exposure light passing though each of the optical members, the substrate being positioned opposite the optical members; and
    a liquid immersion system that causes a space between each of the optical members and the substrate to be filled with the liquid.

2. The exposure apparatus according to claim 1, wherein the liquid immersion system has a supply port that supplies the liquid.

3. The exposure apparatus according to claim 2, wherein the liquid immersion system has a plurality of supply ports corresponding to the plurality of optical members.

4. The exposure apparatus according to claim 2 or 3, wherein the supply port is placed between the optical members.

5. The exposure apparatus according to any one of claims 1 to 4, wherein the liquid immersion system has a collection port that recovers the liquid.

6. The exposure apparatus according to claim 5, wherein the liquid immersion system has a plurality of collection ports corresponding to the plurality of optical members.

7. The exposure apparatus according to claim 5 or 6, wherein the collection port is placed so as to surround the optical members.

8. The exposure apparatus according to any one of claims 1 to 7, wherein the liquid immersion system forms a single liquid immersion area on the substrate such that a space between each of the optical members and the substrate is filled with the liquid.

9. The exposure apparatus according to any one of claims 1 to 7, wherein the liquid immersion system forms a plurality of liquid immersion areas on the substrate such that spaces between each of the optical members and the substrate are filled with the liquid.

10. The exposure apparatus according to any one of claims 1 to 9, further comprising: a liquid contact surface that is located between the optical members and between which and the substrate the liquid is held.

11. The exposure apparatus according to any one of claims 1 to 10, wherein a refractive index of the optical member relative to the exposure light is greater than a refractive index of the liquid relative to the exposure light.

12. The exposure apparatus according to any one of claims 1 to 11, wherein the refractive index of the liquid is approximately 1.5 or more.

13. The exposure apparatus according to any one of claims 1 to 12, wherein the refractive index of the optical member is approximately 1.6 or more.

14. The exposure apparatus according to any one of claims 1 to 13, wherein irradiation areas of the exposure light from the optical members are located in different positions in at least a first direction on a predetermined plane, and, during the exposure, the plurality of irradiation areas and the substrate are moved relatively to each other in a direction that is parallel to the predetermined plane.

15. The exposure apparatus according to claim 14, wherein the optical members are each placed in positions where end portions of the irradiation areas overlap in the first direction with irradiation areas of adjacent optical members.

16. The exposure apparatus according to claim 14 or 15, wherein the optical members are placed such that the irradiation areas are separated in the first direction.

17. The exposure apparatus according to any one of claims 14 to 16, wherein the optical members are each placed in positions where, in a second direction that intersects the first direction, the irradiation areas are different from irradiation areas of adjacent optical members.

18. The exposure apparatus according to any one of claims 14 to 17, wherein during the exposure, the plurality of irradiation areas and the substrate are moved relatively in a second direction that intersects the first direction.

19. An exposure apparatus that exposes a substrate via a liquid using exposure light, comprising:

an optical system having a plurality of optical members, irradiation areas of the exposure light from the optical members being in different positions in at least a first direction on a predetermined plane; a movement system that, during the exposure, moves the plurality of irradiation areas and the substrate relatively to each other in a second direction that intersects the first direction; and a liquid immersion system that, during the exposure, fills a space between at least one of the optical members through which the exposure light passes and the substrate with the liquid so as to form a liquid immersion space.

20. The exposure apparatus according to claim 19, wherein a refractive index of the optical member is greater than that of synthetic quartz or fluorite.

21. The exposure apparatus according to claim 19 or 20, wherein the refractive index of the optical member is approximately 1.6 or more.

22. The exposure apparatus according to claim 19, wherein a light emission surface of the optical member has a concave surface facing the predetermined plane.

23. The exposure apparatus according to any one of claims 19 to 22, wherein a refractive index of the liquid is greater than that of pure water.

24. The exposure apparatus according to any one of claims 19 to 23, wherein the refractive index of the liquid is approximately 1.5 or more.

25. The exposure apparatus according to any one of claims 19 to 24, wherein the refractive index of the optical member is greater than that of the liquid.

26. The exposure apparatus according to any one of claims 19 to 25, wherein the liquid immersion system is capable of forming the liquid immersion space for each of the optical members.

27. The exposure apparatus according to claim 26, wherein, for each of the optical members, the liquid immersion system has a supply port that supplies the liquid and a collection port that recovers the liquid.

28. The exposure apparatus according to any one of claims 19 to 25, wherein, during the exposure, the immersion system forms at least one liquid immersion area on at least some of the optical members through which the exposure light passes.

29. The exposure apparatus according to claim 28, wherein the liquid immersion system has a plurality of supply ports that supply the liquid and a collection port that recovers the liquid.

30. The exposure apparatus according to any one of claims 1 to 29, wherein each of the optical members forms at least a portion of a projection optical system that projects a pattern image on the substrate.

31. The exposure apparatus according to any one of claims 1 to 30, wherein the substrate includes a semiconductor wafer.

32. A device manufacturing method that uses the exposure apparatus according to any one of claims 1 to 31.

33. An exposure method for exposing a substrate via a liquid using exposure light, the method comprising:

    forming a liquid immersion space for the liquid between at least one of optical members through which the exposure light passes and the substrate; and
    exposing the substrate by the exposure light via at least one of the optical members and the liquid in the liquid immersion space.

34. The exposure method according to clam 33, wherein positions of irradiation areas of the exposure light from the optical members are different in at least a first direction on a predetermined plane, and, during the exposure, the plurality of irradiation areas and the substrate are moved relatively to each other in a direction that is parallel to the predetermined plane.

35. The exposure method according to claim 34, wherein positions of at least some of the irradiation areas are different in a second direction that intersects the first direction.

36. The exposure method according to claim 34 or 35, wherein, during the exposure, the plurality of irradiation areas and the substrate are moved relatively to each other in a second direction that intersects the first direction.

37. The exposure apparatus according to claim any one of claims 33 to 36, wherein the refractive index of the optical member is approximately 1.6 or more.

38. The exposure apparatus according to any one of claims 33 to 36, wherein a light emission surface of the optical member has a concave surface facing the predetermined plane.

39. The exposure apparatus according to any one of claims 33 to 38, wherein the refractive index of the liquid is approximately 1.5 or more.

40. The exposure apparatus according to any one of claims 33 to 39, wherein the refractive index of the optical member is greater than that of the liquid.

41. The exposure apparatus according to any one of claims 33 to 40, wherein the substrate includes a semiconductor wafer.

42. A device manufacturing method that uses the exposure apparatus according to any one of claims 33 to 41.

# FIG. 1

EP 1 950 612 A1

# FIG. 2

# FIG. 3

EP 1 950 612 A1

FIG.4

FIG. 5

# FIG.6

# FIG. 7

# FIG. 8

# FIG. 9

[FIRST SCAN EXPOSURE]

50a
50b
50c
50d
50e
50f
50g
51b
50a
50h
51m
50b
50c
50d
50e
50f
50g
50h

[SECOND SCAN EXPOSURE]

Y
X

EP 1 950 612 A1

# FIG. 10

EP 1 950 612 A1

# FIG. 11

EP 1 950 612 A1

FIG.12

EP 1 950 612 A1

# FIG. 13

LR(LQ)

SH

LR(LQ)
50b

50a

LR(LQ)
50c

LR(LQ)
50d

LR(LQ)
50e

LR(LQ)
50f

LR(LQ)
50g

LR(LQ)
50h

Y

X

FIG.14

# FIG. 15

201

DESIGN
(FUNCTIONS, PERFORMANCE, PATTERN)

203

MANUFACTURE
SUBSTRATE

202

PREPARE MASK

204

PROCESS SUBSTRATE

205

ASSEMBLE DEVICE

206

INSPECTION

(SHIPPING)

## INTERNATIONAL SEARCH REPORT

| | International application No. |
|---|---|
| | PCT/JP2006/322168 |

A. CLASSIFICATION OF SUBJECT MATTER
*G03F7/20*(2006.01)i, *H01L21/027*(2006.01)i

According to International Patent Classification (IPC) or to both national classification and IPC

B. FIELDS SEARCHED

Minimum documentation searched (classification system followed by classification symbols)
G03F7/20, H01L21/027

Documentation searched other than minimum documentation to the extent that such documents are included in the fields searched
Jitsuyo Shinan Koho       1922-1996   Jitsuyo Shinan Toroku Koho   1996-2007
Kokai Jitsuyo Shinan Koho  1971-2007   Toroku Jitsuyo Shinan Koho   1994-2007

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | US 2005/0243298 A1  (ASML NETHERLANDS B.V.),<br>03 November, 2005 (03.11.05),<br>Par. Nos. [0053], [0118]<br>& JP 2005-317970 A       & US 2005/0243295 A1 | 1-42 |
| X | JP 2005-236291 A  (ASML NETHERLANDS B.V.),<br>02 September, 2005 (02.09.05),<br>Par. Nos. [0022], [0044]<br>& US 2005/0179884 A1       & EP 1566697 A2 | 1-42 |
| A | JP 2005-077533 A  (Nikon Corp.),<br>24 March, 2005 (24.03.05),<br>Page 1<br>(Family: none) | 11-13,20,21,<br>24,25,37,39,<br>40 |

| [X] Further documents are listed in the continuation of Box C. | [ ] See patent family annex. |
|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>31 January, 2007 (31.01.07) | Date of mailing of the international search report<br>06 February, 2007 (06.02.07) |
|---|---|
| Name and mailing address of the ISA/<br>Japanese Patent Office | Authorized officer |
| Facsimile No. | Telephone No. |

Form PCT/ISA/210 (second sheet) (April 2005)

**EP 1 950 612 A1**

**INTERNATIONAL SEARCH REPORT**

| International application No. |
| --- |
| PCT/JP2006/322168 |

C (Continuation).　DOCUMENTS CONSIDERED TO BE RELEVANT

| Category* | Citation of document, with indication, where appropriate, of the relevant passages | Relevant to claim No. |
| --- | --- | --- |
| A | JP 2005-019864 A　(Canon Inc.),<br>20 January, 2005 (20.01.05),<br>Par. Nos. [0097] to [0101], [0139] to [0149];<br>Figs. 6, 7, 13, 14<br>& US 2004/0263809 A1 | 1-42 |
| A | JP 2003-203853 A　(Nikon Corp.),<br>18 July, 2003 (18.07.03),<br>Page 1<br>& US 2003/0227607 A1 | 1-42 |
| A | JP 2001-337463 A　(Nikon Corp.),<br>07 December, 2001 (07.12.01),<br>Page 1<br>& US 2002/0005940 A1 | 1-42 |

Form PCT/ISA/210 (continuation of second sheet) (April 2005)

34

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005324618 A
- WO 9949504 A
- JP 2000260684 A
- US 6781672 B
- JP H08130179 B
- US 6721034 B
- JP 2001510577 W
- WO 199928790 A
- JP 2004289126 A
- US 20040165159 A
- EP 1420298 A
- WO 2004055803 A
- WO 2004057590 A
- WO 2005029559 A
- WO 2004086468 A
- US 20050280791 A1
- US 6952253 B
- WO 2005059617 A
- WO 2005059618 A
- WO 2004090956 A

- US 20060023188 A1
- WO 199946835 A
- US 7023610 B
- JP H10163099 B
- JP H10214783 B
- US 6590634 B
- JP 2000505958 W
- US 5969441 A
- US 6208407 B
- JP H11135400 B
- WO 199923692 A
- JP 2000164504 A
- JP 6897963 B
- JP H06124873 B
- JP H10303114 B
- US 5825043 A
- US 6778257 B
- WO 2001035168 A
- JP 2004519850 W
- US 6611316 B